(19)

**Europäisches Patentamt**
**European Patent Office**
**Office européen des brevets**

(11) **EP 4 645 613 A1**

(12) **EUROPEAN PATENT APPLICATION**

(43) Date of publication:
**05.11.2025 Bulletin 2025/45**

(21) Application number: **24305683.5**

(22) Date of filing: **30.04.2024**

(51) International Patent Classification (IPC):
*H01S 5/026* (2006.01)  *H01S 5/06* (2006.01)
*H01S 5/0625* (2006.01)  *H01S 5/00* (2006.01)
*H01S 5/028* (2006.01)  *H01S 5/343* (2006.01)
*H01S 5/042* (2006.01)  *H01S 3/23* (2006.01)

(52) Cooperative Patent Classification (CPC):
**H01S 5/06258; G01S 7/4814; G01S 7/4911;**
**G01S 17/34; G01S 17/58; H01S 5/0261;**
**H01S 5/0612;** H01S 3/2308; H01S 5/0014;
H01S 5/0085; H01S 5/0287; H01S 5/0425;
H01S 5/34306; H01S 2301/02

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **Almae Technologies**
**91460 Marcoussis (FR)**

(72) Inventor: **Debrégeas, Hélène**
**Boullay-les-Troux (FR)**

(74) Representative: **Osha BWB**
**2, rue de la Paix**
**75002 Paris (FR)**

(54) **DISTRIBUTED FEEDBACK LASERS AND SYSTEMS COMPRISING SUCH LASERS**

(57) According to a first aspect, the present disclosure relates to a distributed feedback (DFB) laser configured to control a wavelength of emitted light from the DFB laser, the DFB laser comprising a planar substrate, a substantially planar front facet with an anti-reflective coating, the front facet substantially perpendicular to the planar substrate, a substantially planar rear facet with a high reflectivity coating, the rear facet substantially perpendicular to the planar substrate, a laser section positioned between the rear facet and the front facet, the laser section comprising: a first ensemble of substantially planar layers configured to produce, with said planar substrate, a first PIN junction, the first ensemble of substantially planar layers comprising: a first top layer substantially parallel to the planar substrate; an active layer substantially parallel to the planar substrate and configured to emit light through the front facet, the active layer arranged between the planar substrate and the first top layer; a grating layer arranged substantially parallel to the active layer, the grating layer arranged between the planar substrate and the first top layer in proximity to the active layer; a Bragg grating arranged in said grating layer and configured to reflect light towards said front facet; and a phase section positioned between the rear facet and the laser section, the phase section comprising: a second ensemble of substantially planar layers comprising: a second top layer substantially parallel to the planar substrate, the second top layer substantially coplanar with the first top layer; an optical layer arranged between the planar substrate and the second top layer, the optical layer substantially coplanar with the active layer and optically coupled with the active layer; a non-grating layer substantially coplanar with the grating layer; and an element in electrical or thermal contact with the optical layer, the element configured, under application of a current or voltage, to change a refractive index of the optical layer so as to change the wavelength of the emitted light.

FIG.3A

EP 4 645 613 A1

**Description**

TECHNICAL FIELD OF THE INVENTION

The present description relates to distributed feedback lasers. Further, the present description relates to systems incorporating distributed feedback lasers and methods of using such systems.

BACKGROUND OF THE INVENTION

Semiconductor devices configured to emit light are used in many technical fields such as optical sensing and optical communications. Distributed feedback (DFB) lasers are a particular type of semiconductor devices with a laser section comprising an active layer configured to emit light and a Bragg grating configured to select a central wavelength of the emitted light. The active layer is undoped and is arranged between P-doped layers and N-doped layers. The Bragg grating is arranged in a planar layer that is parallel to said active layer. Further, in such devices, the laser section is arranged between a front facet and a rear facet, the light being emitted out of the device through the front facet. Several designs of DFB lasers are known.

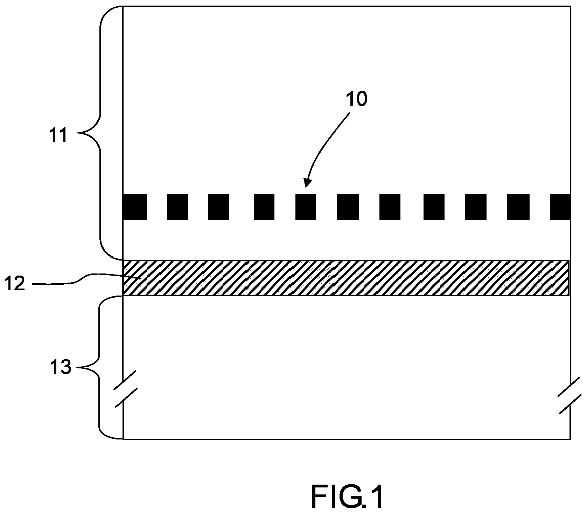

FIG. 1 represents a commonly used design of a DFB laser. Such a design comprises an N-doped layer 13 arranged on a substrate side, a P-doped layer 11, a Bragg grating 10 that is arranged in said P-doped layer 11, and an undoped active layer 12 arranged between the N-doped layer 13 and the Bragg grating 10. Alternatively, the grating layer 10 could be arranged in the N-doped layer 13.

For most applications, a single-mode operation of the laser is generally preferred, i.e. when the emitted light has a bandwidth predominantly centered at a single wavelength. However, in a DFB laser, the presence of the Bragg grating in the laser section generally favors emission of light at two different wavelengths (dual-mode operation) separated by a spectral range referred to as the stopband of the laser. The stop-band depends on the product of the length (L) of the laser section and the coupling coefficient ($\kappa$) of the laser section, wherein the coupling coefficient is also referred to as the coupling strength, defined as the "reflectivity per unit length" of the DFB laser and expressed in cm$^{-1}$. In order to avoid dual-mode operation, an asymmetry is generally introduced in the DFB laser by adding, on the one hand, a mirror section consisting of a highly reflective (HR) coating at the rear facet and, on the other hand, an anti-reflection (AR) coating at the front facet. With said arrangement, referred to as HR/AR DFB lasers, one of the two modes in operation is favored over the other mode. Further, the optical power of the light emitted at the front facet is substantially doubled compared to a DFB laser without coatings, as almost no light is emitted through the rear facet.

However, it is generally not possible to control the exact position of the rear facet with respect to the Bragg grating, mainly due the imprecision of the cleaving process (typically +-10$\mu$m). As a result, upon back-and-forth propagation in the laser section and reflection on the HR coating, light generated in the active layer acquires a phase shift that cannot be predicted, which is also referred to as a "random phase condition". Such random phase condition leads to variable performances between distinct DFB lasers, such as variations of the output power and variations of the wavelength of the emitted light within the stop-band. This is a known effect of DFB lasers, which is for example explained in REF [1].

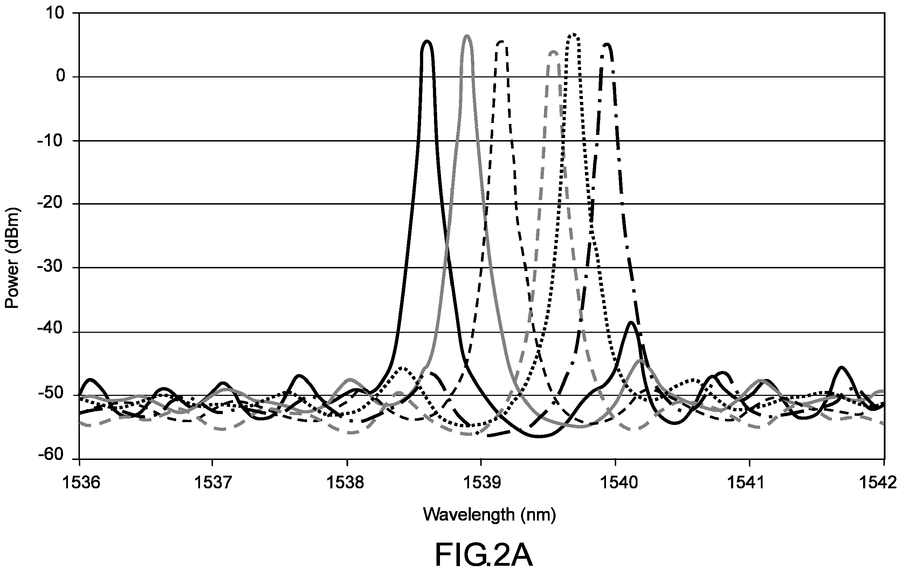

The above effect is illustrated in FIG.2A that shows experimental emission spectra acquired by the Applicant for a number of different DFB lasers within a same DFB laser bar or array. FIG. 2A illustrates the emitted optical power (dBm) of the different DFB lasers against wavelength. The difference in the emitted wavelength for each laser corresponds to a specific random phase condition, which differs across the lasers.

In some applications, such as Light Detecting and Ranging (LIDAR) (REF [2] - [4]), it is desirable to sweep the wavelength of emitted light from the DFB laser over a range of wavelengths.

For a DFB laser, the emission wavelength for a given optical mode is given by

$$\lambda = 2.\, n_{eff}.\Lambda \qquad \text{EQUATION 1}$$

where $n_{eff}$ is the effective index of the optical mode, and $\Lambda$ is the Bragg grating pitch.

Current injected into the DFB laser may comprise a bias current component (or average current), and a modulating current component, where the current is modulated (or varied) about the bias current component. The amplitude of the bias current component is herein denoted I. The amplitude of the modulating current component is the difference between the highest value of the modulating current component and the lowest value of the modulating current component and is denoted $\Delta$I. For example, I may be 200mA and $\Delta$I may be 6mA, i.e. the current modulates about 200mA, where the amplitude of the modulating current component $\Delta$I is 6mA.

By modulating the current injected into the DFB laser ($\Delta$I), the laser temperature is modulated by the Joule effect. When the semiconductor crystal heats up, it expands, its optical index increases and so does the effective index $n_{eff}$ of the optical mode. The wavelength $\lambda$ emitted therefore also varies, corresponding to a variation in the optical frequency $f = c/\lambda,$

where f is the optical frequency, and c is the velocity of light in air.

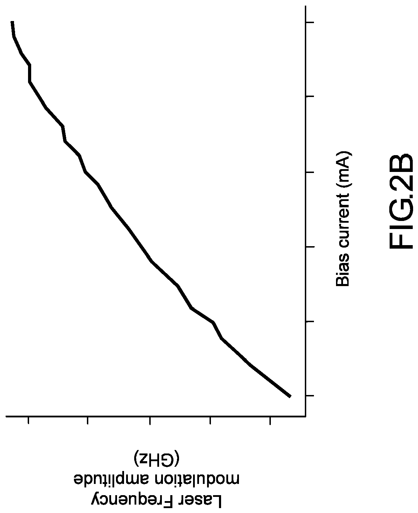

The temperature variation $\Delta T$ is due to the modulation current component ($\Delta I$) and the bias current component I. In particular, $\Delta T$ is proportional to $(I+\Delta I)^2-I^2$. FIG. 2B illustrates an experimental plot showing the non-linear relationship between the amplitude of the laser frequency modulation (in GHz) for a bias current with a modulation current component amplitude $\Delta I$ (which in the example of FIG. 2B is 6 mA) plotted against the bias current component I injected into a DFB laser.

Furthermore, the whole laser cavity must be heated, leading to a slow effect with multiple time constants. As a result, the amplitude of frequency modulation depends on the periodicity of the current modulation, and also has slow transient effects. For example, if current modulation is fast (faster than thermal dissipation), then it will not be efficient, and there will be very little frequency modulation. If current modulation is slow, thermal effects (temperature change) will have time to follow, and the current modulation will entirely translate into frequency modulation. Therefore, for the same amplitude of the modulation current component (e.g. 6 mA), the generated temperature variation - hence frequency modulation amplitude - will depend on the speed of the current modulation.

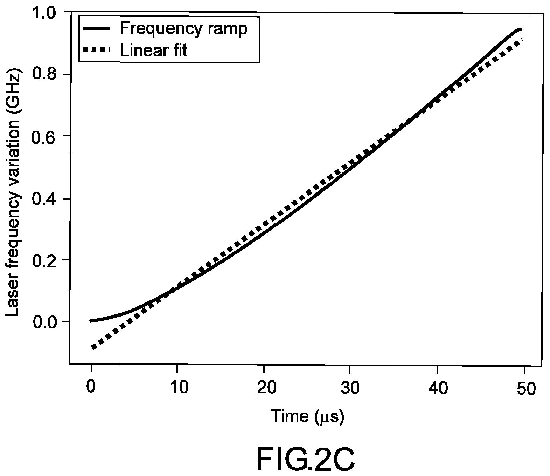

FIG. 2C illustrates an experimental plot of the laser frequency variation against time for an applied current where the bias current amplitude I=200mA and modulation current component amplitude $\Delta I$ = 6mA. The time axis illustrates the time for the modulation current to change from 0mA (at 0$\mu$s) to 6mA at 50 $\mu$s. The dotted line in FIG. 2C shows a linear fit of the plot. The plot has a deviation from linearity (as illustrated by the linear fit) of around 2.8%.

Overall, current modulation techniques of DFB lasers do not generate linear frequency slots as shown in Fig.2C, so the response of the DFB laser is non-linear. In other words, the change in frequency of the DFB laser against modulation current is not linear. As a result, methods are needed to pre-compensate for this non-linear response by applying a non-linear electrical periodic signal. This complexifies the system, especially as the non-linearity response of the DFB laser is dependent on operating conditions, such as laser bias current, temperature, modulation periodicity, thermal assembly, etc.

In addition, current modulation generates a variation in laser power, but can also have an impact on its linewidth. The linewidth (or line width) of a laser, e.g. a single-frequency laser, is the width of its optical spectrum. It is the width of the power spectral density of the emitted electric field in terms of frequency, or wavelength.

There is therefore a need for alternative designs of distributed feedback lasers so that the wavelength of emitted light can be controlled, and also to allow for sweeping the emitted light across the stopband

SUMMARY

In what follows, the term "comprise" is synonym of (means the same as) "include" and "contains", is inclusive and open, and does not exclude other non-recited elements. Moreover, in the present disclosure, when referring to a numerical value, the terms "about" and "substantially" are synonyms of (mean the same as) a range comprised between 80% and 120%, preferably between 90% and 110%, of the numerical value.

According to a first aspect, the present description relates to a distributed feedback (DFB) laser configured to control a wavelength of emitted light from the DFB laser, the DFB laser comprising:

a planar substrate;
a substantially planar front facet with an anti-reflective coating, the front facet substantially perpendicular to the planar substrate;
a substantially planar rear facet with a high reflectivity coating, the rear facet substantially perpendicular to the planar substrate;
a laser section positioned between the rear facet and the front facet, the laser section comprising:
a first ensemble of substantially planar layers configured to produce, with said planar substrate, a first PIN junction, the first ensemble of substantially planar layers comprising:

a first top layer substantially parallel to the planar substrate;
an active layer substantially parallel to the planar substrate and configured to emit light through the front facet, the active layer arranged between the planar substrate and the first top layer;
a grating layer arranged substantially parallel to the active layer, the grating layer arranged between the planar substrate and the first top layer in proximity to the active layer;
a Bragg grating arranged in said grating layer and configured to reflect light towards said front facet; and

a phase section positioned between the rear facet and the laser section, the phase section comprising:
a second ensemble of substantially planar layers comprising:

a second top layer substantially parallel to the planar substrate, the second top layer substantially coplanar with the first top layer;

an optical layer arranged between the planar substrate and the second top layer, the optical layer substantially coplanar with the active layer and optically coupled with the active layer;

a non-grating layer substantially coplanar with the grating layer; and

an element in electrical or thermal contact with the optical layer, the element configured, under application of a current or voltage, to change a refractive index of the optical layer so as to change the wavelength of the emitted light.

In embodiments of the present description, two planar layers (a first planar layer and a second planar layer) are said to be coplanar when a median plane of the first planar layer is at a predetermined distance from a median plane of the second of the two planar layers, wherein said distance is inferior to a maximum distance, for example equal or inferior to about 120 nm. Conversely, two planar layers are not coplanar when said predetermined distance is superior to said maximum distance.

According to one or further embodiments, when a first planar layer is coplanar with a second planar layer, an upper surface of the first of the two planar layers is at a predetermined distance from an upper surface of the second of the two planar layers that is inferior to a maximum distance, wherein said maximum distance is for example equal or inferior to about 50 nanometers, for example equal or inferior to about 20 nanometers.

In embodiments of the present description, two planar layers (a first planar layer and a second planar layer) are perpendicular when a median plane of the first planar layer is substantially perpendicular to a median plane of the second planar layer. In other words, a median plane of the first planar layer forms an angle of 90° with a median plane of the second planar layer.

In an embodiment of the present description, two planar layers (a first planar layer and a second planar layer) are said to be parallel when a median plane of the first planar layer is parallel to a median plane of the second planar layer. In other words, the median plane of the first planar layer does not intersect with the median plane of the second planar layer.

According to one or further embodiments, when a first planar layer is said to be parallel to a second planar layer, a top surface of the first planar layer is at a predetermined distance from the bottom surface of the second planar layer, where the predetermined distance is greater than zero.

In embodiments of the present invention, the front facet comprises an anti-reflective coating so that a reflection coefficient of light at a predetermined wavelength on the front facet is inferior or equal to about 5%.

In embodiments of the present invention, the rear facet comprises a high reflectivity coating so that a reflection coefficient of light at a predetermined wavelength on the rear facet is greater than or equal to 80%.

In the DFB laser according to the first aspect, the element of the phase section enables the refractive index of the optical layer in the phase section to be changed, hence causing a change in wavelength of the light emitted from the DFB laser. Using the element, it is possible to obtain continuous and regular tunability over the width of the stopband. This is advantageous in applications where precise emission wavelengths of DFB lasers need to be controlled.

According to one or further embodiments, the element is a heating element configured to cause a change in temperature of the optical layer. By using a heating element, thermal tuning of the phase section can be achieved. When using a heating element to cause a change in the refractive index of the optical layer, the thermal effect is much slower than the electrical noise from current sources. As a result, the electrical noise is filtered out and does not result in any parasitic modulation of the phase. As a result, therefore no linewidth degradation of the emitted light.

According to one or further embodiments, heating of the element is achieved by injecting a current into a first electrode electrically coupled to the element, where the current flows through the element to a second electrode electrically coupled to the element.

According to one or further embodiments, wherein the element is a heating element configured to cause a change in temperature of the optical layer, the optical layer is formed of the same material as the active layer, the second top layer is formed of the same material as the first top layer, and the laser further comprises an electrode layer substantially parallel to the planar substrate and disposed so that the first top layer and at least a portion of the second top layer are between the planar substrate and the electrode layer, wherein the electrode layer is in electrical contact with the optical layer and the active layer, wherein the element is electrically isolated from the electrode layer.

According to one or further embodiments, the element is an electrode configured to inject current into the optical layer.

According to one or further embodiments, the element is placed in electrical contact with the second top layer, such that the second top layer is disposed between the element and the optical layer.

According to one or further embodiments, the optical layer is formed of the same material as the active layer (314).

Advantageously, this arrangement enables the phase section to additionally participate to optical power emission from the DFB laser.

According to a second aspect, the present description relates to a frequency-modulated continuous wave LIDAR system comprising: a laser beam emission module comprising: a distributed feedback (DFB) laser according to the first aspect; and a sweeping control unit configured to change a current or voltage applied to the element of the DFB laser (300), so as to sweep a wavelength of light emitted by the DFB laser across a portion of a stopband of the DFB laser.

The frequency-modulated continuous wave (FMCW) LIDAR system using a DFB laser with a phase section enables faster frequency modulation, with adjustable amplitude, independent of the laser section of the DFB laser, with no impact on the power and linewidth of the laser section. This results in a high performance FMCW-LIDAR system.

According to a third aspect, the present description relates to a method of using a frequency-modulated continuous wave LIDAR system according to the second aspect, the method comprising: changing, using the sweeping control unit, a current or voltage applied to the element of the DFB laser; directing the light emitted from the DFB laser to an object, where the light emitted from the DFB laser is reflected by the object; and determining, based on the reflected light from the object, a speed of the object and/or a distance between the LIDAR system and the object.

The presented method enables a high-quality laser signal to be generated, resulting in improved performance and determination of the speed of the object and/or the distance of the object from the LIDAR system.

According to a fourth aspect, the present description relates to a system comprising the DFB laser according to the first aspect, and at least one of a modulator or a semiconductor optical amplifier (SOA). The modulator or SOA is optically coupled to the DFB laser, and emitted light from the DFB laser is modulated by the modulator or amplified by the semiconductor optical amplifier. By adjusting the wavelength of the light emitted from the DFB laser, the sensitivity of the modulator or SOA to optical feedback can be controlled.

According to a fifth aspect, the present description relates to an array of DFB lasers according to the first aspect. By tuning the wavelength of the DFB lasers using the phase sections, the wavelengths emitted by the array of DFB lasers can be controlled. For example, this will enable an array of DFB lasers all outputting the same wavelength, or for the wavelengths of the DFB lasers to uniformly span a wavelength range.

BRIEF DESCRIPTION OF DRAWINGS

Other advantages and features of the invention will become apparent on reading the description, illustrated by the following figures which represent:

- FIG. 1, already described, illustrates a commonly used design of a DFB laser, according to the prior art;
- FIG. 2A, already described, illustrates experimental emission spectra for a number of different AR/HR standard DFB lasers;
- FIG. 2B, already described, illustrates an experimental plot of the laser frequency modulation for a modulation current component amplitude of 6mA plotted against the average current injected into a DFB laser;
- FIG. 2C already described, illustrates an experimental plot of the laser frequency against time during a current ramp;
- FIG. 3A illustrates a cross-section of a DFB laser according to the present disclosure;
- FIG. 3B illustrates a top view of the DFB laser of FIG. 3A;
- FIG. 3C illustrates a top view of the DFB laser of FIG. 3A;
- FIG. 4A illustrates superimposed emission spectra of a DFB with a rear phase section;
- FIG. 4B illustrates a plot of wavelength of the emitted light against the phase section current for the spectra of FIG. 4A;
- FIG. 5A illustrates calculated plots of required heating against phase section length for different stop-band coverages;
- FIG. 5B illustrates a calculated plot from FIG. 5A on an alternative scale;
- FIG. 6A illustrates a cross-section of a DFB laser according to the present disclosure;
- FIG. 6B illustrates a top view of the DFB laser of FIG. 6A;
- FIG. 7 illustrates a frequency-modulated continuous wave LIDAR system according to the present invention;
- FIG. 8A illustrates example waveforms to illustrate the operation of the FMCW-LIDAR system of FIG. 7;
- FIG. 8B illustrates example waveforms to illustrate the operation of the FMCW-LIDAR system of FIG. 7.
- FIG. 9A to 9J illustrate the steps of fabricating the DFB laser according to an embodiment.

DETAILED DESCRIPTION

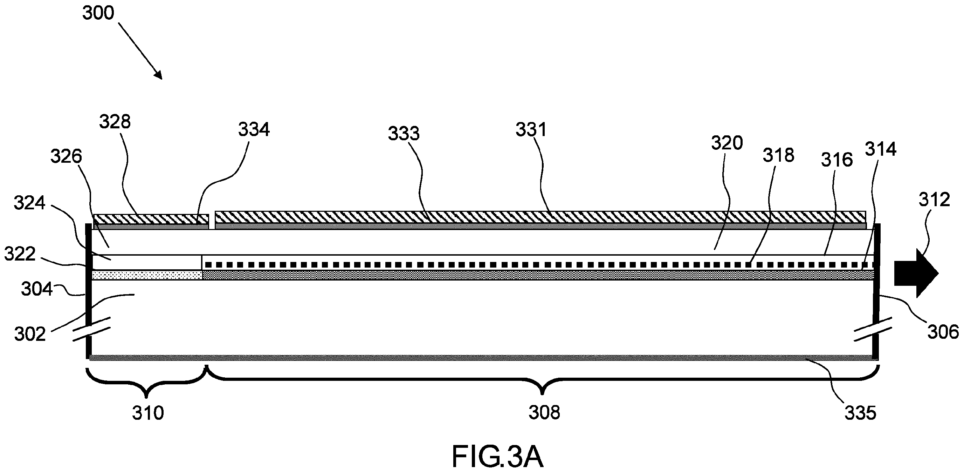

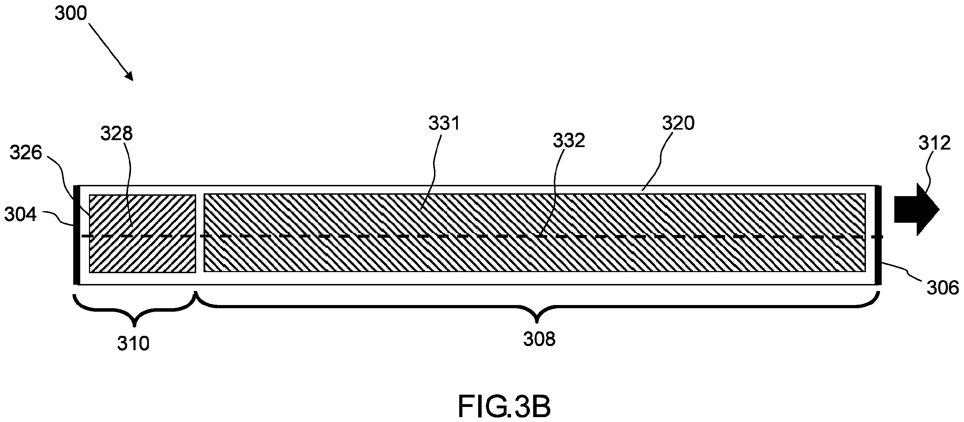

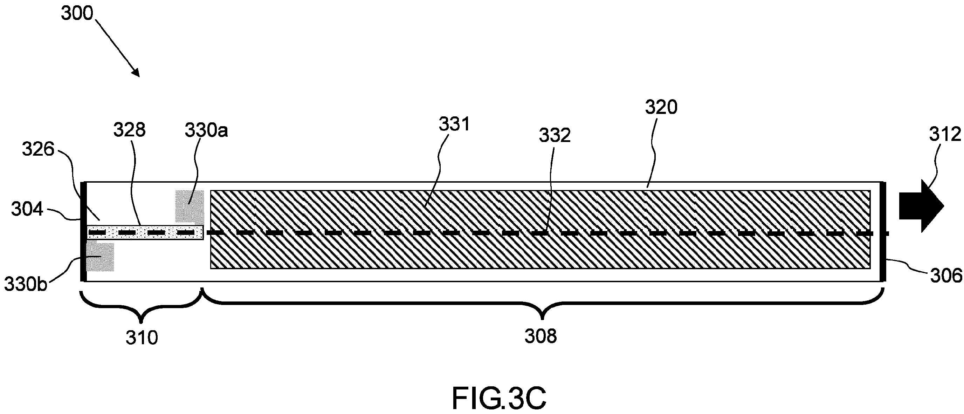

FIG. 3A shows a cross-section of a DFB laser 300 according to the present disclosure. FIG. 3B shows a top view of the DFB laser of FIG. 3A according to an embodiment. FIG. 3C shows a top view of the DFB laser of FIG. 3A according to another embodiment.

The DFB laser 300 comprises a planar substrate 302, a rear facet 304, a front facet 306, a laser section 308 and a phase section 310. The laser section 308 is configured to emit light 312 through the front facet 306 to the outside of the DFB laser 300. The direction of propagation of the emitted light 312 from the DFB laser 300 is substantially parallel to a plane of the planar substrate 302. The phase section 310 is configured to control a wavelength of the emitted light 312 within a stopband of the DFB laser 300, as will be described in detail below.

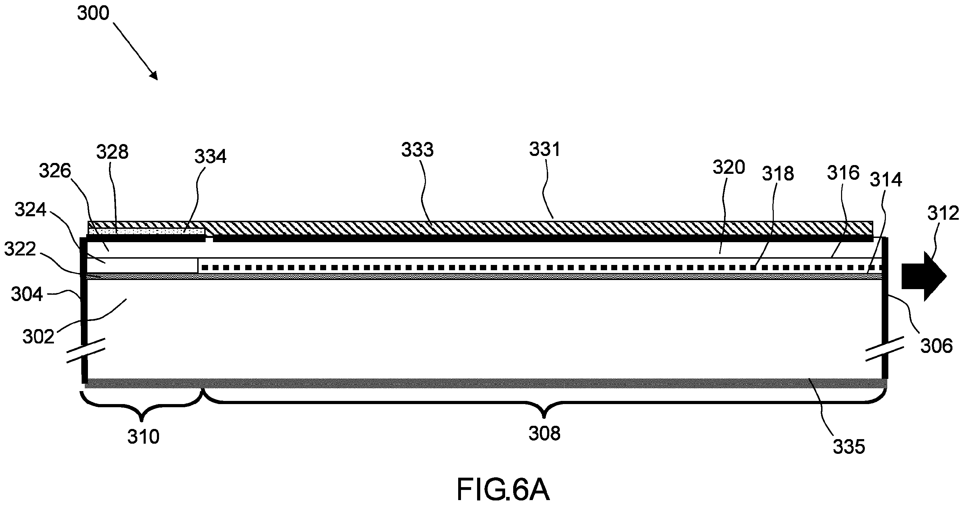

The planar substrate 302 extends across the laser section 308 and the phase section 310. The planar substrate 302 may be an N-doped planar substrate comprising N-doped material, such as N-doped InP (indium phosphide). In embodiments, the planar substrate 302 is generally thicker than other layers of the DFB laser 300, which is represented in FIG. 3A (and similarly in FIG. 6A) by broken lines in the figure. Although not represented, the planar substrate 302 may comprise an upper region comprising said N-doped material, for example N-doped InP, and a lower region, generally thicker, comprising semi-insulating material such as semi-insulating InP.

The rear facet 304 and the front facet 306 may be formed during a cleaving process, such as when a wafer comprising a multiplicity of semiconductor structures is cleaved to form individual devices or structures. The term facet is used to define a side of the DFB laser 300 where the DFB laser 300 has been cleaved (in the case of InP devices). The term facet refers to a plane perpendicular to the planar substrate 302, and other semiconductor layers of the laser section 308 and the phase section 310, and defines an interface between semiconductor layers of the DFB laser 300 and air.

The rear facet 304 is substantially perpendicular to the planar substrate 302. The rear facet 304 comprises a high reflectivity coating to reflect light incident on the rear facet 304 back towards the laser section 308. The high reflectivity coating is a coating applied to the rear facet 304 to increase the reflectance of light at a predetermined wavelength from the rear facet 304 while reducing transmission, absorption and scattering of the light at the rear facet 304. In particular, rear facet 304 may comprise a high reflectivity coating so that a reflection coefficient of light at a predetermined wavelength on the rear facet 304 is greater than or equal to 80%. According to embodiments, the high reflectivity coating comprises multiple layers of dielectrics, for example a layer of Si and a layer of $SiO_2$.

The front facet 306 is substantially perpendicular to the planar substrate 302 and is substantially parallel to the rear end facet 304. The front facet 306 comprises an anti-reflection coating configured to facilitate transmission of light at a predetermined wavelength. In particular, the front facet 306 may comprise an anti-reflection coating so that reflection coefficient of light at a predetermined wavelength on the front facet 306 is inferior or equal to about 5%. According to embodiments, the anti-reflection coating comprises a couple of layers such as typically one layer of $TiO_2$ and one layer of $SiO_2$, or a plurality of such couple of layers. However, it will be clear to a person of ordinary skill in the art that other possible materials could be used for the anti-reflection coating.

The laser section 308 is disposed between the phase section 310 and the front facet 306. The laser section 308 comprises the planar substrate 302, an active layer 314, a grating layer 316, a Bragg grating 318 arranged in the grating layer 316, and a first top layer p-doped layer 320.

The active layer 314 is disposed on top of the planar substrate 302. The active layer 314 is substantially parallel to the planar substrate 302. The active layer 314 may comprise an ensemble of semiconductor layers, for example multi-quantum wells based on InGaAsP or InGaAlAs or other ternary or quaternary materials. The active layer 314 is formed of a material having a refractive index $n_{active}$, where refractive index describes how the material affects the speed of light travelling through it. The velocity of light in the active layer 314 is given by $v_{active} = {}^{c}/{n_{active}}$ , where c is the free space velocity.

The grating layer 316 is substantially parallel to the active layer 314. In FIG. 3A, the grating layer 316 is located between the first top layer 320 and the active layer 314 in a P-side design. The grating layer 316 may comprise a P-doped quaternary material such as P-doped InGaAsP. The Bragg grating 318 is arranged in the grating layer 316, for example defined by an etch through said InGaAsP layer then buried into P-doped InP material, such as that used for the first top layer 320. Therefore, the Bragg grating 318, and hence the grating layer 316, consists of alternating high-index regions of layer 316 (e.g. InGaAsP) and low-index regions of P-InP layer 320. The grating layer 316 may also comprise a thin spacing layer between the active layer 314 and the Bragg grating 318 to control a spacing between the active layer 314 and the Bragg grating 318. The grating layer 316 may also comprise a thin layer at a side of the Bragg grating 318 opposite the active layer 314, which is formed of the same material as the first top layer 320, such as P-doped InP.

In an alternative embodiment, the grating layer 316 is located between the planar substrate 302 and the active layer 314 in an N-side design. In an N-side design, the grating layer 316 may comprise an N-doped quaternary material such as N-doped InGaAsP. The Bragg grating 318 is defined by an etch through said grating layer 316 then buried into N-doped InP. Therefore, it consists of alternating high-index regions of grating layer 316 (e.g. InGaAsP) and low-index regions of N-InP planar substrate 302.

In both configurations, the high-index regions and the low-index regions are arranged periodically, where the periodicity is given by a predetermined grating pitch.

According to EQUATION 1, the grating pitch depends on the desired wavelength of the emitted light, and may for example be comprised between about 190 nanometers and about 250 nanometers for telecom wavelengths, wherein telecom wavelengths are wavelengths comprised between about 1270 nm nanometers and about 1580 nm. For LIDAR, the wavelength is typically around 1550 nm. For $n_{eff}$ equal to 3.2, this leads to pitches around 240 nm for LIDAR applications. In an embodiment, the Bragg grating 318 is a uniform grating, with a constant pitch.

In an embodiment, the first top layer 320 comprises P-doped material, such as P-doped InP.

Such an ensemble of layers forms a first PIN junction.

The laser section 308 may be configured to emit light when a voltage or current is applied between the top layer 320 and the planar substrate 302 or between materials electrically connected to the top layer 320 and the planar substrate 302. In operation, the active layer 314 is configured to emit light at a predetermined single wavelength.

As illustrated in FIG. 3A, the laser section 308 may be covered at least partially by a top electrode layer 331 configured to provide ohmic contact to the first top layer 320, for example in order to apply a voltage or current to the DFB laser 300 so that it emits light. The top electrode layer 331 may comprise, for example, metallic materials such as Platinum (Pt), Titanium (Ti) or Gold (Au). According to embodiments, the laser section 308 may comprise a first contact layer 333 between the first top layer 320 and the top electrode layer 331 so as to reduce the ohmic contact resistance between the first top layer 320 and the top electrode layer 331. In an embodiment, the first contact layer 333 may comprise highly doped InAsP.

The phase section 310 is disposed between the rear facet 304 and the laser section 308. The phase section 310 comprises the planar substrate 302, an optical layer 322, a non-grating layer 324, a second top layer 326, and an element 328 configured to change a refractive index of the optical layer 322.

The optical layer 322 is disposed on top of the planar substrate 302. The optical layer 322 is parallel the planar substrate 302. The optical layer 322 is coplanar with and optically coupled to the active layer 314 of the laser section 308. The optical layer 322 is a waveguide or a section of a waveguide. The optical layer 322 and the active layer 314 together form a waveguide, so that light propagating in the optical layer 322 is propagated in the active layer 314.

The waveguide formed by the optical layer 322 and the active layer 314 has a known effective refractive index $n_{eff}$. The effective refractive index $n_{eff}$ is a measure quantifying the phase delay per unit length in a waveguide, relative to the phase delay in a vacuum. The effective index is the sum of the optical confinement of the optical mode in each material (percentage of the optical mode in that material) multiplied by the refractive index of this material, where an optical mode is one solution of the wave equation for the propagation of light in a waveguide. Therefore, the effective index $n_{eff}$ depends on the structural shape of the waveguide, such as its physical dimensions, that generate the optical mode shape. The effective index $n_{eff}$ also depends on the refractive index of each material, which varies with light wavelength and as well with temperature.

A change in the refractive index of the optical layer 322 causes a change in the effective refractive index of the waveguide. For example, an increase in the refractive index of the optical layers 322 corresponds to an increase in the effective refractive index of the waveguide. The wavelength $\lambda$ emitted therefore also varies, corresponding to a variation in the optical frequency $f = c / \lambda$.

The optical layer 322 may be a passive layer or an active layer. An active layer contains a material providing optical gain by stimulated emission at the operating wavelength, allowing for amplification of optical power of the propagating mode. A passive layer, on the other hand, has a bandgap energy higher than the energy range of the operating wavelength of the laser, and so cannot provide for optical amplification at the operating wavelength.

The optical coupling between the optical layer 322 and the active layer 314 to form the waveguide can be achieved by a butt-joint technique, or any other known photonic integration approach.

The second top layer 326 is substantially parallel to the optical layer 322. In an embodiment, the second top layer 326 comprises P-doped material, such as P-doped InP. The second top layer 326 is substantially coplanar with the first top layer 320. The second top layer 326 may be formed of the same material as the first top layer 320. In an embodiment, the second top layer 326 and the first top layer 320 may be formed of the same material so as to form a single top layer. The second top layer 326 is disposed so that the optical layer 322 is disposed between the second top layer 326 and the planar substrate 302, so as to form a second PIN junction.

The non-grating layer 324 is a layer formed of a single material and that has not been etched to comprise a Bragg grating. In other words, the non-grating layer 324 has not been etched with a periodic etching to form a Bragg grating. As a result, the non-grating layer 324 has a substantially uniform refractive index. The non-grating layer 324 is substantially parallel to the optical layer 322. The non-grating layer 324 is substantially co-planar with the grating layer 316. In FIG. 3A, the non-grating layer 324 is located between the second top layer 326 and the optical layer 322 to correspond with the P-side design of the laser section 308.

In alternative embodiment, the non-grating layer 324 is located between the planar substrate 302 and the optical layer 322 to correspond with an N-side design of the laser section 308.

The phase section 310 does not comprise a Bragg grating.

The element 328 is configured to change the effective refractive index of the phase section 310, by changing the refractive index of the optical layer 322. In this way, it is possible to shift the wavelength of the emitted light 312 and sweep the wavelength of the emitted light 312 across the stop-band of the DFB laser 300. As a result, phase tunability is achieved.

In an embodiment, the element 328 is configured to inject current into the optical layer 322. In this embodiment, the element 328 is placed in electrical contact with the second top layer 326, such that the second top layer 326 is disposed between the element 328 and the optical layer 322. In this embodiment, the element 328 is an electrode configured to inject electrical current into the optical layer 322. In this embodiment, the carrier density injected into the optical layer 322 of the phase section 310 increases with the current, which reduces the refractive index of the optical layer 322 by plasma effect. In this way, all the random phase conditions of the reflectivity seen by the Bragg grating 318 of the laser section 308 can be scanned.

In an embodiment, there may be a second contact layer 334 between the element 328 and the second top layer 326 so as to reduce the ohmic contact resistance between the second top layer 326 and the element 328.

In an embodiment, the DFB laser 300 may further comprise a bottom metallisation layer 335 disposed on a side of the planar substrate opposite to the active layer 314 and optical layer 322.

FIG. 3B illustrates a top view of the DFB laser of FIG. 3A, where the element 328 is configured to inject current into the optical layer 322. The element 328 may be coupled to a first terminal of a current or voltage source. In an embodiment, the bottom metallisation layer 335 (see FIG. 3A) is also connected to a second terminal of a current or voltage source, for example to act as a ground plane.

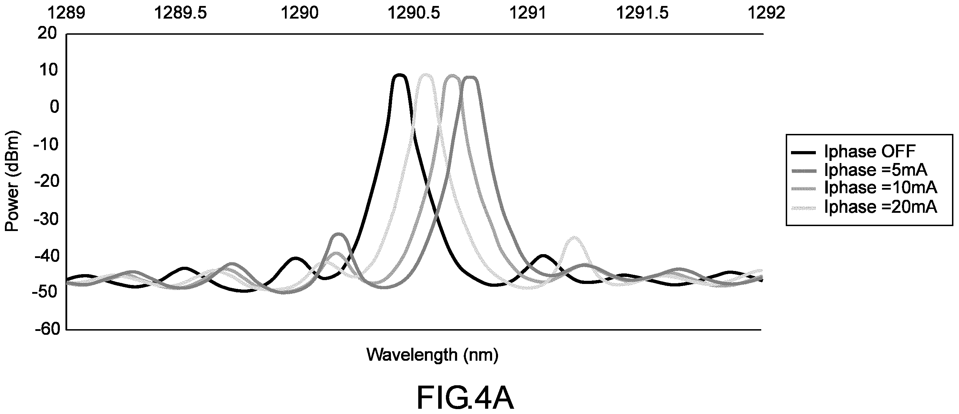

FIG. 4A illustrates some example emission spectra of a DFB with rear phase section 310, where the current to the phase section 310 $I_{phase}$ has been changed. The centre wavelength of the emitted light in each case changes depending on the applied current.

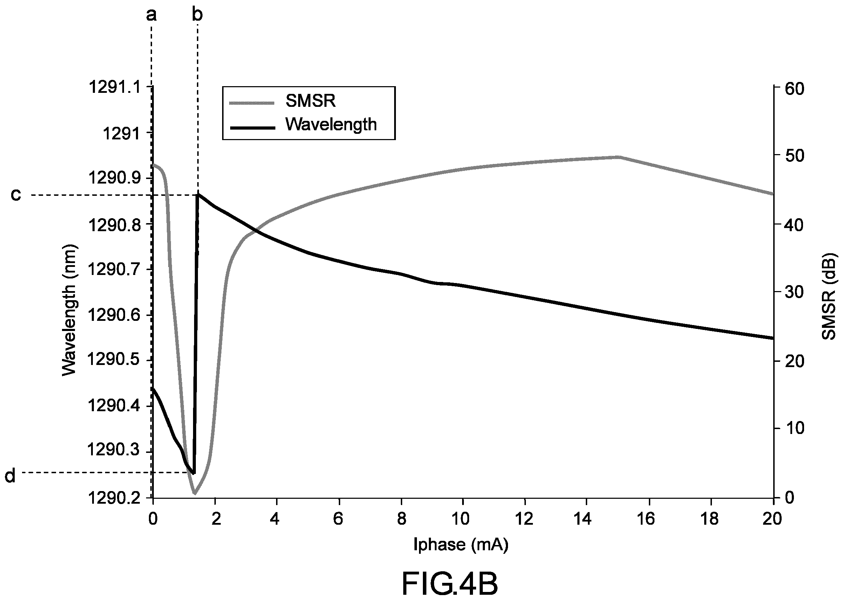

FIG. 4B illustrates a plot of wavelength of the emitted light against the phase section 310 current $I_{phase}$ for the spectra of FIG. 4A. By increasing the current, for example from a to b, a regular and continuous decrease in wavelength in the stop-band is achieved, where the stopband for the DFB laser 300 is from c to d. When the wavelength of the emitted light 312 reaches the minimum wavelength of the stop-band at d, the DFB laser 300 switches to the maximum wavelength c of the stop-band with a transition to dual-mode operation (two wavelengths are emitted when the phase current is b). As the phase current is increased from b, the DFB laser 300 then reverts to single-mode operation, and continues its continuous tunability with a decrease in wavelength across the stop band for a decrease in current. As can be observed in FIG. 4B, a continuous tuning is obtained inside the stop-band, with a mode jump from one edge to the other of the stop-band at 1.5mA. When no current is applied to the phase section (310) (in other words there is no tuning), the initial value of the wavelength (within the stopband) emitted by the laser 300 is linked to the random phase condition. The current value corresponding to the mode hop from d to b depends on this initial value of the wavelength in the stop-band, and so is also linked to the random phase condition.

FIG. 4B also illustrates a plot of side-mode-suppression-ratio (SMSR) against the phase section 310 current for the spectra of FIG. 4A. SMSR describes the amplitude difference in decibels between the main mode (represented by the central wavelength or lobe in the plots of FIG.4A) and the largest side mode (represented by the lobes to either side of the central lobe in the plots of FIG. 4A). Again, this plot illustrates the continuous tuning that can be obtained across the stopband. A decrease in SMSR may be observed to either side of the mode jump from d to b. Therefore, in operation it may be desirable to operate the laser so that it avoids the mode jump and dual-mode operation, and that it operates within a desirable SMSR range.

In this way, it is possible to obtain continuous and regular tunability over the width of the stopband. For a DFB with a narrow linewidth, using a long cavity (e.g. 800$\mu$m) and a low coupling strength k (e.g. 12cm$^{-1}$), the typical stop-band width is 1 to 1.5nm, i.e. an optical frequency variation of more than 100GHz.

In an alternative embodiment, referring to FIG. 3A and FIG. 3C, the element 328 is a resistive element operating as a heater. The heating element 328 is placed in thermal contact with the optical layer 322, enabling the optical layer 322 to be heated.

The heating element 328 may be a resistive element, such as that described in REF [5]. In FIG. 3C, the dashed line 332 illustrates a location of an optical axis of the active layer 314 and the optical layer 322 beneath the first top layer 320 and the second top layer 326 respectively. In FIG. 3C, the heating element 328 is placed on the second top layer 326 so that it substantially overlaps the optical layer 322. Alternatively, the heating element 328 may be placed so that there is a spacer element (not shown) between the heating element 328 and the second top layer 326.

In an embodiment, the heating of element 328 is achieved by injecting a current into electrodes 330a 330b electrically coupled to the edges of the heating element 328. For example, a current may be injected into electrode 330a and electrode 330b may be connected to ground. The current will flow from electrode 330a though element 328 to electrode 330b, causing the element 328 to heat up, dissipate heat and heat the optical layer 322 and other layers of the phase section 310. In an alternative embodiment, an electrical voltage can be applied between the electrodes 330a and 330b, causing a heating of the element 328 and a heating of the optical layer 322 and other layers of the phase section 310.

The electrodes 330a 330b may comprise, for example, metallic materials such as Platinum (Pt), Titanium (Ti) or Gold (Au).

The increase in heating of the optical layer 322 and other layers of the phase section 310 causes a corresponding increase in the refractive index of the optical layer 322 and other layers of the phase section 310 and a corresponding increase in the effective index of the waveguide formed by the optical layer 322. For example, for a waveguide structure emitting around 1.55$\mu$m, the change in effective refractive index is of the order of $\Delta n_{eff}/\Delta T° \sim 2.10^{-4}$ / °C. The heat from the heating element 328 may also heat the active layer 314 or other layers of the laser section 308. However, the applicant has shown that most of the heat from the heating element 328 will be dissipated via the planar substrate 302, and therefore will not substantially impact the active layer 314 and other layers of the laser section 308.

An advantage of using a heating element 328 to cause a change in refractive index of the optical layer 322 is that there is no linewidth degradation. A phase section 310 with current injection may result in degradation of the linewidth of the emitted light 312, because an electrical noise on the phase current supply may generate a parasitic modulation of the emission wavelength, thereby bringing phase noise which degrades the linewidth. When using a heating element 328 to cause a change in the refractive index of the optical layer 322, the thermal effect is much slower than the electrical noise from current sources. As a result, the electrical noise is filtered out and does not result in any parasitic modulation of the phase. As a result, therefore there is no linewidth degradation.

In an embodiment, the element 328 operating as a heater may be a high-resistivity metal layer, such as a NiCr (Nickel Chromium) layer. Alternatively, other metallisations could be used. Alternatively, the element 328 could consist of a dummy PIN or PN junction parallel to the waveguide, which generates heating by Joule effect when injecting an electric current or voltage.

In the embodiment where the element 328 is a heater the second top layer 326 does not need to be doped as the phase section 310 does not need to form a PIN stack for the thermal tuning to work.

Light generated in the active layer 314 of the laser section 308 propagates partially towards the phase section 310, through the phase section 310 and is reflected back towards the laser section 308 upon reflection by the HR coating on the rear facet 304. When the refractive index of the optical layer 322 is changed by heating or current injection, it alters the phase condition seen by the Bragg grating 318 of the laser section 308. This modifies the longitudinal oscillation condition of the optical wave in the laser section 308, which shifts the wavelength of the emitted light 312 within the stop-band as explained in REF [1], and as seen in Fig. 4A and 4B.

The modulation efficiency by increasing phase section 310 temperature ($\Delta f / \Delta T°_{phase}$) can be chosen simply by adjusting the length of the phase section 310 as explained below.

The maximum tunability corresponding to the width of the stop-band is imposed by the coupling coefficient ($\kappa$) (also known as the laser grating strength). Typically, the stopband width is 1 - 1.5nm, which corresponds to 125 - 190GHz. In order to tune over the entire width of the stop-band, the phase section 310 needs to be able to modify the phase of the light travelling within it by $2\pi$. Therefore, the optical path along the phase section 310 needs to be modified by one wavelength. The optical path length is the distance the light travels times the effective refractive index, therefore:

$$\Delta \text{optical pathlength} = \Delta n_{eff}.L = \lambda \qquad \text{EQUATION 2}$$

where L is the length of the phase section, $\lambda$ is the wavelength of emitted light, and $\Delta n_{eff}$ is the change in the effective refractive index.

The heating to cover the entire stop-band tuning range is given by

$$\Delta T° = \frac{\lambda}{L.\dfrac{\Delta n_{eff}}{\Delta T°}} \qquad \text{EQUATION 3}$$

Based on this equation, the heating of the phase section 310 to cover the whole stop-band based on its length can be determined.

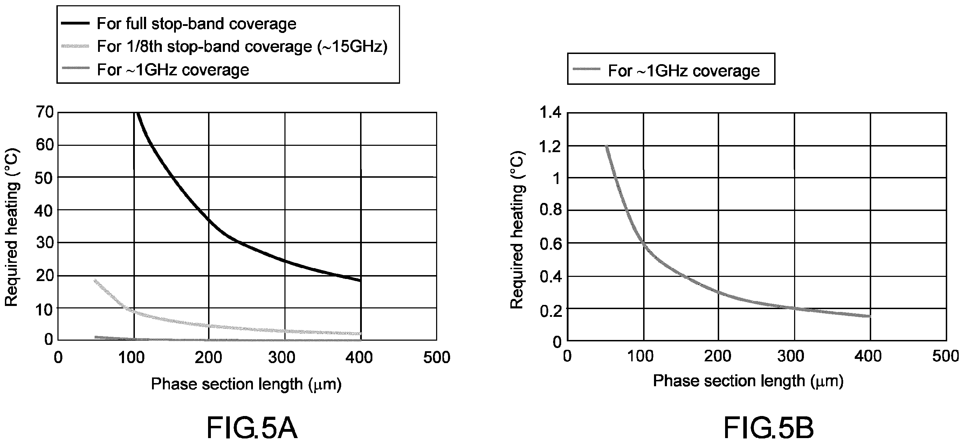

FIG. 5A illustrates calculated plots of heating against phase section 310 length for different stop-band coverages, in particular for full stop-band coverage, 1/8th stopband coverage and for 1 GHz coverage. FIG. 5B illustrates an enlarged plot for 1 GHz coverage of FIG. 5A on an alternative scale.

In many applications, the desired tunability (the range over which the wavelength of emitted light needs to be changed) of a DFB laser 300 is much less than the full stop-band. The highest values are in the order of 15GHz maximum, i.e. 1/8th of the stop-band. From the 1/8th stopband coverage plot in FIG. 5A, it is shown that for a phase section 310 of 200μm, a change in temperature of $\Delta T° < 5°C$ is required. As shown in FIG. 5B, for 1GHz coverage, a change in temperature of $\Delta T° < 1.2°C$ is required for a phase section 310 of 50μm. Therefore, for a given desired tunability range, the length of the phase section 310 and the required heating change can be chosen.

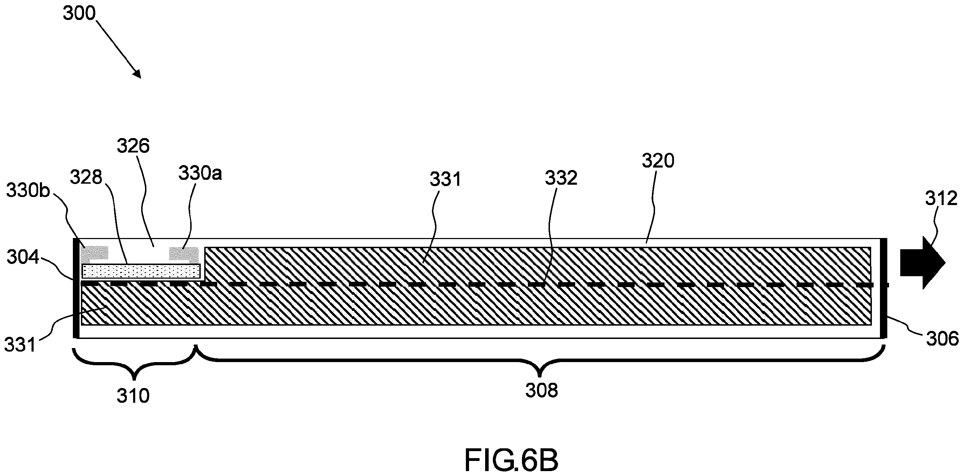

FIG. 3A and FIG. 3B illustrate a DFB with a passive optical layer 322 in the phase section 310. In an alternative embodiment, as illustrated in FIG. 6A and FIG. 6B, the optical layer 322 can be an active section, formed of the same material as the active layer 314 of the laser section 308. This simplifies the fabrication process as only one type of stack is required. The first top layer 320 and the second top layer 326 may be formed of the same material. In an embodiment, the second top layer 326 and the first top layer 320 may be formed of the same material so as to form a single top layer. This enables the phase section 310 and the laser section 308, to form a single pin stack. However, the phase section 310 does not have a Bragg grating. The phase section 310 can then be injected with electric current by the same first contact layer 333 and top electrode layer 331 as the laser section 308. In this way, the phase section 310 can additionally participate to optical power emission from the DFB laser 300. The heating element 328 is positioned as close as possible to the waveguide formed of the optical layer 322 and the active layer 314 for maximum efficiency, but electrically insulated from the common first contact layer and top metal layer 333.

The phase section 310 of the DFB laser 300 allows a slight continuous tuning of the emission wavelength (for example, 1 - 1.5nm maximum) and can therefore be used to precisely control the wavelength of the DFB laser 300. This can be used in applications including telecom networks or for sensing applications.

The phase section 310 can also be used to precisely control the phase condition between the Bragg grating 318 and the rear facet 304 to influence laser performance, such as emitted power, or sensitivity to optical feedback.

A DFB laser 300 according to the present invention is of particular use for Light Detecting and Ranging (LIDAR) applications in optical metrology, as described further below.

Current LIDAR systems generally use 905nm lasers because they are commercially available. However, LIDAR systems are now moving towards lasers operating around 1550nm because this wavelength provides increased eye safety.

The classic approach for LIDAR is based on Time of Flight (ToF) measurement. In this approach, a laser sends out pulses, and the distance to obstacles is calculated from the time between emission of the pulse and reception of the reflected signal.

Another approach that has recently attracted a great deal of interest is Frequency-Modulated Continuous Wave LIDAR (FMCW-LIDAR), which is based on coherent detection. FMCW-LIDAR offers much better immunity to environmental conditions (fog, rain, snow) and a better signal-to-noise ratio than ToF. With continuous power emission, FMCW-LIDAR avoids the ocular risks of high-power peaks from pulsed lasers. Furthermore, it can simultaneously measure not only distance, but also the movement of objects using the Doppler effect. This feature makes it a key solution for autonomous cars. It can also be used in the fields of architecture, aeronautics, aerospace, security, etc.

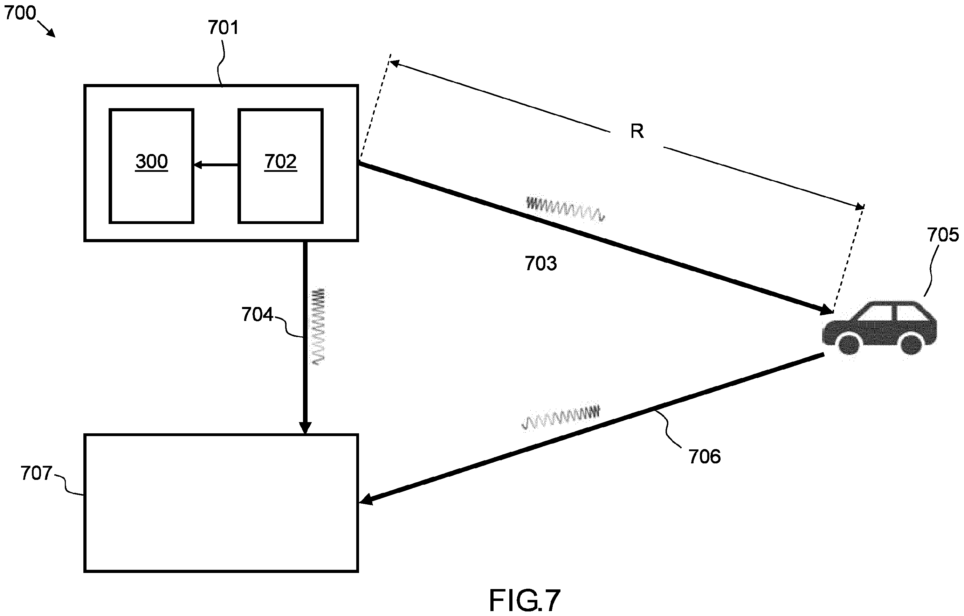

FIG. 7 illustrates a frequency-modulated continuous wave LIDAR system 700 according to the present invention. The FMCW-LIDAR system 700 comprises a laser beam emission module 701 and a photodetector and processing module 707.

The laser beam emission module 701 comprises a DFB laser 300 according to the present description, for example a DFB laser as previously described. The DFB laser 300 generates for example a continuous signal whose frequency is modulated by periodic linear steps. The modulation is achieved by varying the current or voltage applied to the element of the phase section 310 of the DFB laser 300, for example a heating element.

The laser beam emission module 701 may further include a sweeping control unit 702, configured to control the element 328 of the DFB laser 300, so as to change the wavelength of light emitted by the DFB laser 300 across a portion of the stopband of the DFB laser 300.

The sweeping control unit 702 may be configured to apply a current or voltage to the element 328.

The output of the DFB laser 300 is then split into two signals so as to output a reference light signal 704 and a sample light signal 703 from the laser module 701. In an embodiment, the splitting of the DFB laser 300 output may be achieved using a beam splitter, such as a cube beamsplitter or a plate beamsplitter (not shown).

The photodetector and processing module 707 comprises a photodetector configured to convert light, optical signal, into an electrical signal.

The sample light signal 703 is reflected by an object 705, and so shifted in time. The reflected sample light signal 706 is reflected to the photodetector of the module 707. The reference light signal 704 from the laser module 701 is sent directly to the photodetector of the module 707.

The interaction between the reflected sample light signal 706 and the reference light signal 704 at the photodetector is measured.

The photodetector and processing module 707 is configured to use in a known manner the reflected sample light 706 and reference light signal 704 to determine a distance R and/or velocity v of the object 705.

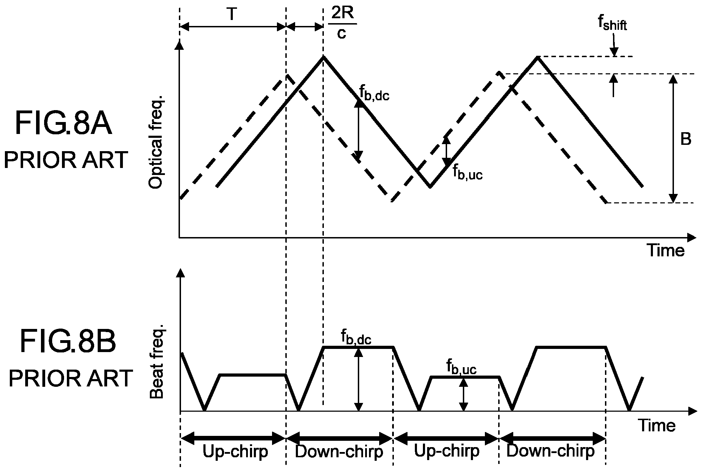

FIG. 8A illustrates example waveforms to illustrate the operation of FMCW-LIDAR, as known in the art.

The frequency of the reflected sample light signal 706 is $f_{sample}$. The frequency of the reference light signal 704 is $f_{ref}$. The frequency difference $f_{ref} - f_{sample}$, generated by the time delay of the reflected sample light signal 706 reflected on the object 705, is called the beat frequency $f_b$ and is given by [REF 6]:

$$f_{ref} - f_{sample} = f_b = \frac{2.B}{T.c} R \quad \text{EQUATION 4}$$

where B is the frequency modulation amplitude of the laser beam emission module 701, T is the frequency modulation period of the laser beam emission module 701, c is the speed of light in air, and R is the distance from the object 705 (see FIG. 7). This beat frequency $f_b$ thus indicates the distance R of the object.

However, if the object 705 is a moving object, the frequency $f_{sample}$ of the reflected sample light signal 706 is modified by the Doppler effect. The Doppler frequency shift of the reflected sample light signal 706 distorts the measured beat frequency. The Doppler frequency shift exhibits different results depending on the wavelength chirping direction (up or down) of the DFB laser 300. Up-chirp is when the optical frequency is changing from a low optical frequency to a high optical frequency. Down-chirp is when the optical frequency is changing from a high optical frequency to a low optical frequency.

FIG. 8B illustrates the change in beat frequency in the cases of up-chirp and down-chirp, for a moving object 705 approaching at a constant speed, as known in the art. The waveforms in FIG. 8B correspond to those in FIG. 8A. As shown in Fig. 8A, in the case of an up-chirp, the actual beat frequency is decreased by $f_{b,uc} = f_b - f_{shift}$, where $f_{b,uc}$ is the upchirp beat frequency, and $f_{shift}$ is the Doppler shift. In contrast, during down-chirp, the Doppler shift frequency is added to the beat frequency, and thus, by $f_{b,dc} = f_b + f_{shift}$, where $f_{b,dc}$ is the downchirp beat frequency.

Therefore, the beat frequency of the up-chirp $f_{b,uc}$ and down-chirp $f_{b,dc}$ can be used together to determine the beat frequency $f_b$, and hence the distance R to the object 705, and the Doppler shift:

$$f_{shift} = \left| \frac{f_{beat\_upchip} - f_{beat\_downchirp}}{2} \right| \quad \text{EQUATION 5}$$

where this Doppler frequency shift is a signature of the movement of the object by

$$f_{shift} = \frac{2.v.cos\theta}{\lambda} = \frac{2.v.cos\theta.f_0}{c} \quad \text{EQUATION 6}$$

where $v$ is the velocity of the object, $\theta$ the angle between direction of the movement and the axis between the LIDAR system and the object, and $f_0$ the central frequency emitted by the laser 300.

FMCW-LIDAR performance is closely linked to the quality of the frequency-swept laser. In particular, the following requirements are required of the laser:

- high emitted power, of the order of 60 to 100mW in order to detect objects at sufficient distances (a few hundred metres for the autonomous car) with a good signal to noise ratio;
- the optical frequency must be modulated periodically with linear characteristics over the variation ranges, so that the distance and/or speed of the object can be easily extracted. The frequency modulation amplitude determines the spatial resolution, but it remains quite moderate, in the order of a few GHz;
- the linewidth must be as small as possible, typically <100kHz, as this determines the coherence distance of the laser, and therefore the resolution and maximum detection distance.

In addition, particularly for the consumer application of autonomous cars, the laser must use a low-cost, integrated, robust and reliable technology.

One solution is to use a narrow linewidth continuous laser, and provide frequency modulation with an external modulator such as an acousto-optic modulator, but this makes the source expensive.

A simpler approach is the direct modulation of laser frequency. External cavity FMCW lasers can achieve very narrow linewidths, allowing very long-distance detection. But extremely long cavity can create mode hopping and the tuning is not linear, which requires a complex iterative learning pre-distortion of the electrical signal (REF [2]).

For applications below about 200-300 metres, the main solution for FMCW lasers is a DFB laser, which enables single-wavelength emission, a power of around 100mW (REF [3] REF [4]), and a narrow linewidth down to typically around 150kHz which is sufficient for these detection distances. However, current modulation solutions do not generate linear frequency slots.

The present disclosure consists of integrating a phase section 310 into the DFB laser 300, tuned by an element 328, at the rear of the cavity between the laser section 308 with Bragg grating 318 and the rear facet 304. By injecting electrical power into the element 328, it is possible to change the optical index of this phase section 310, and thus obtain continuous tunability over a few tens of GHz of the wavelength emitted by the DFB.

This is an integrated solution, with simple control, and allows faster frequency modulation, with adjustable amplitude, independent of the laser section 308, with no impact on the power of the laser section 308. Furthermore, in the case of thermal tuning, there is no impact on the linewidth of the laser section 308.

According to an embodiment, the DFB laser is integrated with another optical module. For example, the DFB laser may be integrated with a laser modulator or a semiconductor optical amplifier (SOA), so that the light emitted from the DFB laser is optically coupled to the laser modulator or SOA. Both the laser modulator and the semiconductor amplifier are configured to modulate the light emitted from the DFB laser. By adjusting the wavelength of the light emitted from the DFB laser, the sensitivity of the modulator or SOA to optical feedback can be controlled.

According to an embodiment, a plurality of DFB lasers is combined into an array of DFB lasers. Arrays of lasers are used for different applications, such as telecommunications. Depending on the application, each DFB laser in the array of DFB lasers may need to have the same wavelength, or each DFB laser may need to have a wavelength that is different from the other DFB lasers, for example the wavelengths emitted from the array may need to be uniformly separated across a range of wavelengths. By tuning each DFB laser using the phase section, the wavelength of the emitted light of each DFB laser can be controlled to meet the requirements of the application.

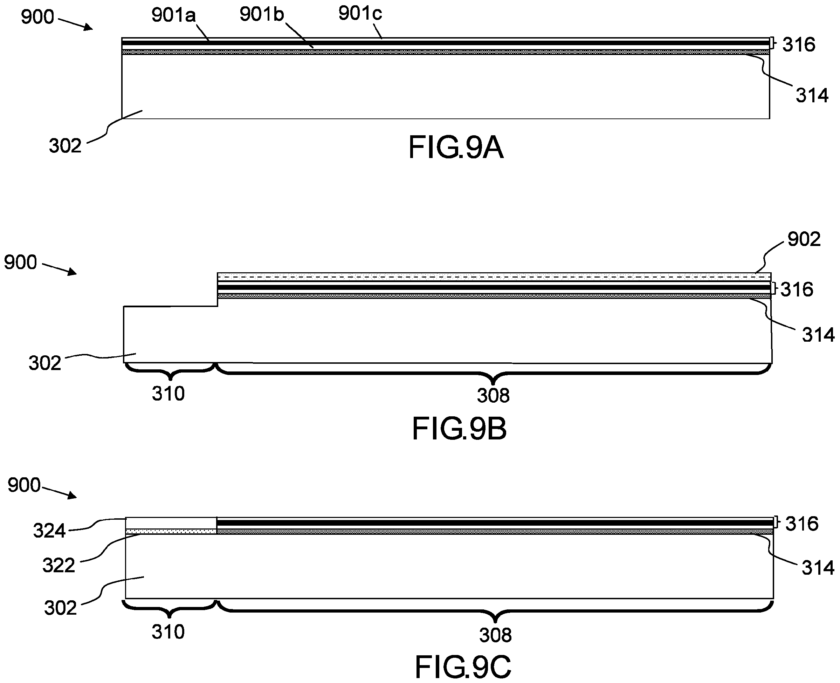

FIG. 9A to 9J illustrates process steps for fabricating a DFB laser 300 according to the present invention. However, it will be clear to a person skilled in the art that these steps may be modified to arrive at the DFB laser 300 of the present disclosure.

The steps are as follows:

STEP 1: Referring to FIG. 9A, on a wafer 900 comprising a planar substrate 302, the layers of the laser section 308 are grown. These include the active layer 314 and the grating layer 316 into which the Bragg grating 318 is to be arranged. The grating layer 316 includes a layer 901a of the material from which the Bragg grating 318 is to be formed. For example, this may be InGaAsP. The grating layer 316 may further include a spacing layer 901b formed of p-InP between the layer 901a and the active layer 314. Additionally, there may be a thin layer 901c of p-InP on a side of the layer 901a opposite the active layer 314.

STEP 2: Referring to FIG. 9B, a mask 902 is used in combination with an etching technique to etch a portion of the grating layer 316 (or layers 901a 901b 901c) and the active layer 314 down to the planar substrate 302 so as to define the laser section 308 and the phase section 310. It will be clear to the skilled person that different types of masks and etching techniques may be used. In one example, the mask is a SiO$_2$ hard mask and the etching technique is inductively coupled plasma (ICP).

STEP 3: Referring to FIG.9C, the phase section 310 stack is now grown on the wafer 900. An optical layer 322 is formed and a non-grating layer 324 is formed on top of the optical layer 322.

The formation of the layers 322, 324 may be considered a butt-joint regrowth. In the case of Gas Source Molecular Beam Epitaxy (GSMB) regrowth some of the material will also deposit as a polycrystal on top of the mask 902 (not shown in FIG. 9C) in the laser section 308. The mask 902 can be removed using fluorhydric acid, thereby also lifting off the top polycrystal.

It will be clear to the person of ordinary skill in the art that the above steps may be altered to start with forming the layers of the phase section 310, etching these layers to define the laser section 308 and phase section 310, and then forming the layers of the laser section 308.

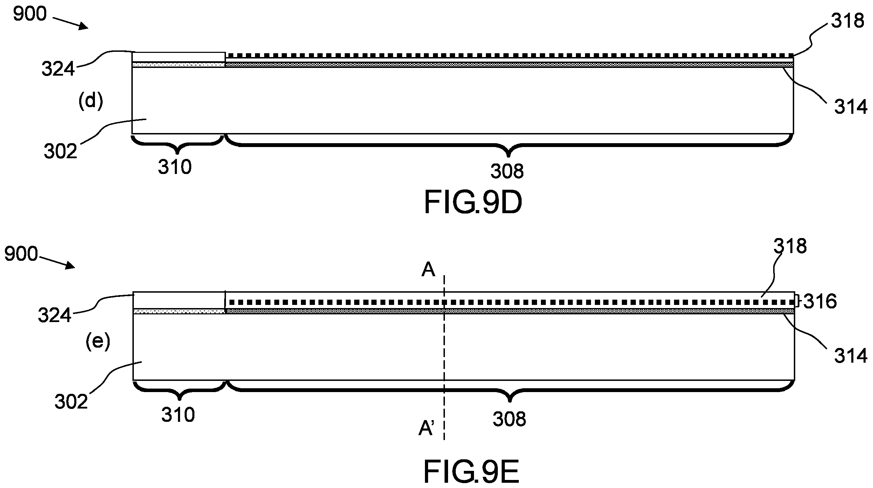

STEP 4: Referring to FIG. 9D, next, the grating layer 316 of the laser section 308 is etched to define the Bragg grating 318. This is achieved by using a mask (for example a SiO$_2$ hard mask) and an etching technique such as ICP to perform a periodic etch of the layer 901a (see FIG. 9A).

During this step, the phase section 310 can be totally protected by a mask (in which case it is not etched during etching, as illustrated in the FIG. 9D). Alternatively, the phase section 310 may not be covered by a mask, in which case it is uniformly etched during etching. No periodic grating is defined in the phase section. Any masks are then removed.

It is noted here that the following steps STEP 5 to 9 are specific to semi-insulating buried heterostructure (SIBH) waveguide technology. When developing other forms of waveguide, such as ridge waveguides, other techniques known in the art may be used.

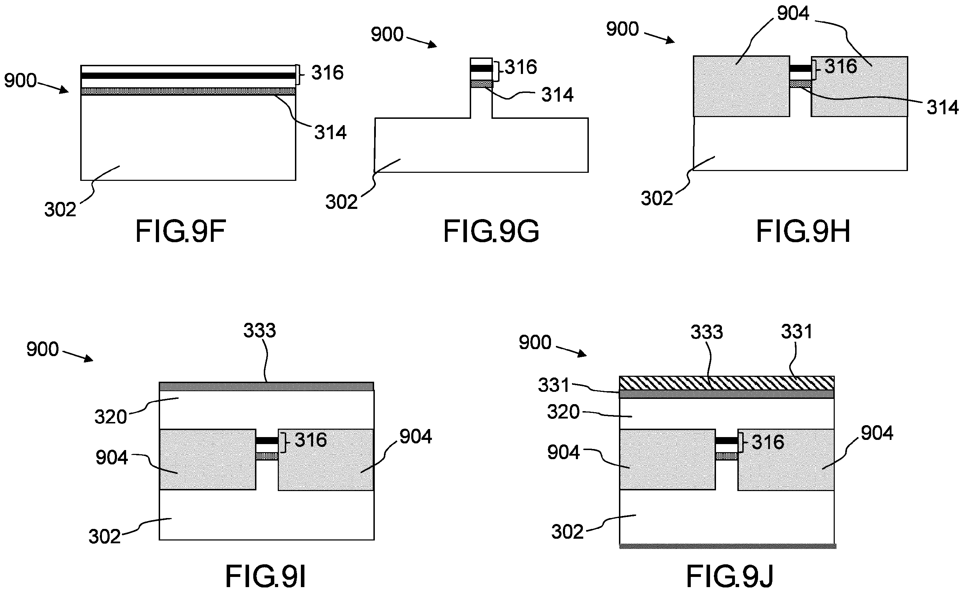

STEP 5: Referring to FIG. 9E, the grating layer 316 may be planarized. In an embodiment, this can be achieved by burying the whole wafer into a thin layer a material which is the same as that of layers 901b or 901c, such as p-doped InP. FIG. 9F shows a cross-sectional view of the wafer 900 of FIG. 9E taken along AA'.

STEP 6: Referring to FIG. 9G, the waveguide may be defined into the layers of the wafer using a mask and etching technique. The layers are etched down and into the planar substrate layer, but not completely through the planar substrate.

STEP 7: Referring to FIG. 9H, in the case of SIBH waveguide technology, the waveguide is then laterally buried into semi-insulating InP layer 902 by Metal Organic Vapor Phase Epitaxy (MOVPE).

STEP 8: Referring to FIG. 9I, in the case of SIBH waveguide technology, the waveguide mask is suppressed, then the whole wafer 900 is buried into a material which is the same as the layers 901b or 901c such as p-doped InP, so as to form the first top layer 320 and the second top layer 326 (not shown in FIG. 9I), and the first contact layer 333 and the second contact layer 334 (not shown in FIG. 9I) are formed, typically by burying the wafer 900 into highly doped InAsP.

STEP 9: Referring to FIG. 9J, top layer metallisation processes may then be carried out to form the element 328 (not shown in FIG. 9J) and the top electrode layer 331. Additional processes, such as back side metallisation to form the bottom metallisation layer 335 or thinning may additionally be carried out. The final DFB laser 300 structure is that detailed in any one of FIGS. 4A to 4C or FIGs 6A to 6B.

While the invention above has been described using examples of semiconductor material from InP semiconductor technology, it will be clear to a person of ordinary skill in the art that other materials such as those used in GaAs (Gallium arsenide) semiconductor technology can be used.

While the invention has been described with respect to a limited number of embodiments, those skilled in the art,

**EP 4 645 613 A1**

having benefit of this disclosure, will appreciate that other embodiments can be devised which do not depart from the spirit of the invention as disclosed herein. Accordingly, the scope of the invention should be limited only by the attached claims.

REFERENCES

REF [1] Larry A. Coldren, Scott W. Corzine, Milan L. Mašanović, "Diode Lasers and Photonic Integrated Circuits", Wiley, 9 February 2012, section 3.7.

REF [2] Y.Wu et al., « Narrow linewidth external cavity laser capable of high repetition frequency tuning for FMCW LIDAR", IEEE Photonics Technology Letters, Vol.34, n° 21, Nov 2022.

REF [3] Caiming Sun, Zhen Chen, Shusheng Ye, Jing Lin, Wu Shi, Binghui Li, Fei Teng, Xuejin Li, and Aidong Zhang, "Highly-time-resolved FMCW LiDAR with synchronously-nonlinearity-corrected acquisition for dynamic locomotion," Opt. Express 31, 7774-7788 (2023)

REF [4] website SIVERS https://www.sivers-semiconductors.com/sivers-photonics/device-types/high-power-dfb-lasers-for-fmcw-lidar/

REF [5] Y. Matsui et al., "Narrow linewidth tunable semiconductor laser," 2016 Compound Semiconductor Week (CSW) [Includes 28th International Conference on Indium Phosphide & Related Materials (IPRM) & 43rd International Symposium on Compound Semiconductors (ISCS), Toyama, Japan, 2016, pp. 1-2, doi: 10.1109/ICIPRM.2016.7528538.

REF [6] H. Jang et al., "Simultaneous distance and vibration mapping of FMCW-LiDAR with akinetic external cavity diode laser", Optics and Lasers in Engineering 160 (2023) 107/283

**Claims**

1. A distributed feedback (DFB) laser (300) configured to control a wavelength of emitted light from the DFB laser, the DFB laser comprising:

   a planar substrate (302);
   a substantially planar front facet (306) with an anti-reflective coating, the front facet substantially perpendicular to the planar substrate (302);
   a substantially planar rear facet (304) with a high reflectivity coating, the rear facet (304) substantially perpendicular to the planar substrate (302);
   a laser section (308) positioned between the rear facet and the front facet, the laser section comprising:
   a first ensemble of substantially planar layers configured to produce, with said planar substrate, a first PIN junction, the first ensemble of substantially planar layers comprising:

   > a first top layer (320) substantially parallel to the planar substrate (302);
   > an active layer (314) substantially parallel to the planar substrate (302) and configured to emit light through the front facet (306), the active layer (314) arranged between the planar substrate (302) and the first top layer (320);
   > a grating layer (316) arranged substantially parallel to the active layer (314), the grating layer (316) arranged between the planar substrate (302) and the first top layer (320) in proximity to the active layer (314);
   > a Bragg grating (318) arranged in said grating layer (316) and configured to reflect light towards said front facet (306); and

   a phase section (310) positioned between the rear facet (304) and the laser section (308), the phase section (310) comprising:
   a second ensemble of substantially planar layers comprising:

   > a second top layer (326) substantially parallel to the planar substrate (302), the second top layer (326) substantially coplanar with the first top layer (320);
   > an optical layer (322) arranged between the planar substrate (302) and the second top layer (326), the optical layer (322) substantially coplanar with the active layer (314) and optically coupled with the active layer (314);
   > a non-grating layer (324) substantially coplanar with the grating layer (316); and
   > an element (328) in electrical or thermal contact with the optical layer (322), the element (328) configured, under application of a current or voltage, to change a refractive index of the optical layer (322) so as to change the wavelength of the emitted light.

2. The distributed feedback (DFB) laser (300) according to claim 1, wherein the element (328) is a heating element configured to cause a change in temperature of the optical layer (322).

3. The distributed feedback (DFB) laser (300) according to claim 2, wherein heating of the element (328) is achieved by injecting a current into a first electrode (330a) electrically coupled to the element (328), where the current flows through the element (328) to a second electrode (330b) electrically coupled to the element (328).

4. The distributed feedback (DFB) laser (300) according to claim 2 or claim 3, wherein the optical layer (322) is formed of the same material as the active layer (314), wherein the second top layer (326) is formed of the same material as the first top layer (320), the laser (300) further comprising:
an electrode layer (331) substantially parallel to the planar substrate (302) and disposed so that the first top layer (320) and at least a portion of the second top layer (326) are between the planar substrate (302) and the electrode layer (331), wherein the electrode layer (331) is in electrical contact with the optical layer (322) and the active layer (314), wherein the element (328) is electrically isolated from the electrode layer (331).

5. The distributed feedback (DFB) laser (300) according to claim 1, wherein the element (328) is an electrode configured to inject current into the optical layer (322)

6. The distributed feedback (DFB) laser (300) according to claim 5, wherein the element (328) is placed in electrical contact with the second top layer (326), such that the second top layer (326) is disposed between the element (328) and the optical layer (322).

7. The distributed feedback (DFB) laser (300) according to claim 5 or claim 6, wherein the optical layer (322) is formed of the same material as the active layer (314).

8. A frequency-modulated continuous wave LIDAR system (700) comprising:
a laser beam emission module (701) comprising:

a distributed feedback (DFB) laser (300) according to any one of claims 1 to 7; and
a sweeping control unit (702) configured to change a current or voltage applied to the element (328) of the DFB laser (300), so as to sweep a wavelength of light (703) emitted by the DFB laser (300) across a portion of a stopband of the DFB laser (300).

9. A method of using a frequency-modulated continuous wave LIDAR system (700) according to claim 8, the method comprising:

changing, using the sweeping control unit (702), a current or voltage applied to the element (328) of the DFB laser (300);
directing the light emitted (703) from the DFB laser (300) to an object (705), where the light emitted from the DFB laser (300) is reflected by the object (705); and
determining, based on the reflected light (706) from the object, a speed of the object (705) and/or a distance between the LIDAR system (700) and the object (705).

10. A system comprising;

the DFB laser according to any one of claims 1 to 7;
and at least one of a modulator or a semiconductor optical amplifier (SOA), the modulator or SOA optically coupled to the DFB laser, wherein emitted light from the DFB laser is modulated by the modulator or amplified by the semiconductor optical amplifier.

11. An array of DFB lasers according to any one of claims 1 to 7.

FIG.1

FIG.2A

Wavelength (nm)

Power (dBm)

FIG.2B

Bias current (mA)

Laser Frequency
modulation amplitude
(GHz)

FIG.2C

EP 4 645 613 A1

FIG.3A

FIG.3B

FIG.3C

FIG.4A

FIG.4B

FIG.5A

FIG.5B

FIG.6A

EP 4 645 613 A1

FIG.6B

FIG.7

FIG.8A
PRIOR ART

FIG.8B
PRIOR ART

FIG.9A

FIG.9B

FIG.9C

900

318

324

(d)

302

310

308

314

**FIG.9D**

900

318

A

324

(e)

302

310

308

A'

316

314

**FIG.9E**

EP 4 645 613 A1

FIG.9F

FIG.9G

FIG.9H

FIG.9I

FIG.9J

Europäisches
Patentamt

European
Patent Office

Office européen
des brevets

# EUROPEAN SEARCH REPORT

**Application Number**

EP 24 30 5683

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 116 345 304 A (XIAMEN SANAN INTEGRATED CIRCUIT CO LTD) 27 June 2023 (2023-06-27) * the whole document * | 1,5-9,11 | INV. H01S5/026 H01S5/06 H01S5/0625 |
| X | US 2020/212652 A1 (KIM NAMJE [KR] ET AL) 2 July 2020 (2020-07-02) * paragraphs [0032] - [0049], [0061] - [0064], [0066] - [0069], [0071] - [0074]; figures 1,9-11 * | 1,2,10, 11 | ADD. H01S5/00 H01S5/028 H01S5/343 H01S5/042 H01S3/23 |
| X | EP 3 726 674 A1 (HORIBA LTD [JP]) 21 October 2020 (2020-10-21) * paragraphs [0023] - [0038], [0044] - [0048], [0053]; figures 1,4 * | 1-3,11 | |
| X | CN 114 256 736 A (NANJING UNIVERSITY OF TECHNOLOGY) 29 March 2022 (2022-03-29) * figure 2 * | 1,11 | |
| X | JP 2006 332375 A (NIPPON TELEGRAPH & TELEPHONE) 7 December 2006 (2006-12-07) * paragraphs [0028], [0051]; figures 1,6 * | 1 | **TECHNICAL FIELDS SEARCHED (IPC)** H01S G01S |
| X | US 2019/097385 A1 (BLAUVELT HENRY A [US]) 28 March 2019 (2019-03-28) * paragraphs [0026], [0036] - [0043], [0054], [0055], [0059], [0064]; figures 1A,3B * | 1-4 | |
| A | US 2007/228550 A1 (ISHIKAWA TSUTOMU [JP]) 4 October 2007 (2007-10-04) * paragraphs [0044] - [0056]; figures 5,6 * | 2-4 | |
| A | US 2013/156052 A1 (DIEHL LAURENT [US] ET AL) 20 June 2013 (2013-06-20) * paragraphs [0040], [0046] - [0047], [0052] - [0054]; figures 3,6-8,10 * | 2-4,11 | |

The present search report has been drawn up for all claims

| Place of search | Date of completion of the search | Examiner |
|---|---|---|
| Munich | 30 October 2024 | Moskowitz, Pamela |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P4C01)

## ANNEX TO THE EUROPEAN SEARCH REPORT
## ON EUROPEAN PATENT APPLICATION NO.

EP 24 30 5683

This annex lists the patent family members relating to the patent documents cited in the above-mentioned European search report.
The members are as contained in the European Patent Office EDP file on
The European Patent Office is in no way liable for these particulars which are merely given for the purpose of information.

30-10-2024

| Patent document cited in search report | | Publication date | Patent family member(s) | | Publication date |
|---|---|---|---|---|---|
| CN 116345304 | A | 27-06-2023 | CN | 116345304 A | 27-06-2023 |
| | | | WO | 2024165037 A1 | 15-08-2024 |
| US 2020212652 | A1 | 02-07-2020 | NONE | | |
| EP 3726674 | A1 | 21-10-2020 | CN | 111344917 A | 26-06-2020 |
| | | | EP | 3726674 A1 | 21-10-2020 |
| | | | JP | 7145877 B2 | 03-10-2022 |
| | | | JP | WO2019116657 A1 | 22-10-2020 |
| | | | US | 2021006037 A1 | 07-01-2021 |
| | | | WO | 2019116657 A1 | 20-06-2019 |
| CN 114256736 | A | 29-03-2022 | NONE | | |
| JP 2006332375 | A | 07-12-2006 | JP | 4630128 B2 | 09-02-2011 |
| | | | JP | 2006332375 A | 07-12-2006 |
| US 2019097385 | A1 | 28-03-2019 | NONE | | |
| US 2007228550 | A1 | 04-10-2007 | EP | 1841024 A1 | 03-10-2007 |
| | | | JP | 2007294914 A | 08-11-2007 |
| | | | US | 2007228550 A1 | 04-10-2007 |
| | | | US | 2010040101 A1 | 18-02-2010 |
| US 2013156052 | A1 | 20-06-2013 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Y.WU et al.** Narrow linewidth external cavity laser capable of high repetition frequency tuning for FMCW LIDAR. *IEEE Photonics Technology Letters*, November 2022, vol. 34 (21)
- **CAIMING SUN** ; **ZHEN CHEN** ; **SHUSHENG YE** ; **JING LIN** ; **WU SHI** ; **BINGHUI LI** ; **FEI TENG** ; **XUEJIN LI** ; **AIDONG ZHANG**. Highly-time-resolved FMCW LiDAR with synchronously-nonlinearity-corrected acquisition for dynamic locomotion. *Opt. Express*, 2023, vol. 31, 7774-7788
- **Y. MATSUI et al.** Narrow linewidth tunable semiconductor laser. *2016 Compound Semiconductor Week (CSW) [Includes 28th International Conference on Indium Phosphide & Related Materials (IPRM) & 43rd International Symposium on Compound Semiconductors (ISCS)*, 2016, 1-2
- **H. JANG et al.** Simultaneous distance and vibration mapping of FMCW-LiDAR with akinetic external cavity diode laser. *Optics and Lasers in Engineering*, 2023, vol. 160 (107), 283